# EUROPEAN PATENT APPLICATION

(11) **EP 2 816 587 A1**
(43) Date of publication of application: **24.12.2014**
(21) Application number: 13749445.6
(22) Date of filing: 21.01.2013
(51) Int. Cl.: H01L 21/205, C30B 25/20, C30B 29/06

(54) **METHOD FOR MANUFACTURING SILICON EPITAXIAL WAFERS**

(30) Priority: 14.02.2012 JP 2012029378
(71) Applicant: Shin-Etsu Handotai Co., Ltd., Tokyo 100-0004 (JP)
(72) Inventor: YOSHIDA, Tomosuke, Annaka-shi Gunma 379-0196 (JP); KASHINO, Hisashi, Annaka-shi Gunma 379-0196 (JP)
(74) Representative: Wibbelmann, Jobst
(86) International application number: PCT/JP2013/000245
(87) International publication number: WO 2013/121696

(57) **Abstract**

The present invention provides a method for manufacturing a silicon epitaxial wafer, characterized in that a silicon epitaxial layer is formed on an N-type silicon single crystal wafer manufactured by doping with arsenic to set a resistivity to 1.0 to 1.7 mΩcm and further doping with carbon, nitrogen, or both carbon and nitrogen. As a result, there can be provided the method for manufacturing a silicon epitaxial wafer that can suppress occurrence of stacking faults at the time of performing epitaxial growth on the arsenic-doped super-low resistance silicon single crystal wafer.

## Description

### TECHNICAL FIELD

The present invention relates to a method for manufacturing a silicon epitaxial wafer having an epitaxial layer formed on a silicon single crystal wafer surface.

### BACKGROUND ART

In a majority of methods for manufacturing semiconductor electronic components, a silicon single crystal that is a starting material is manufactured by a so-called Czochralski (CZ) method or the like. For example, in the CZ method, a seed single crystal is immersed in molten silicon and then slowly pulled up to grow a single crystal. Further, for example, an epitaxial layer is grown on a silicon single crystal wafer fabricated by slicing such a silicon single crystal, thereby manufacturing a silicon epitaxial wafer.

Here, an example of a method for manufacturing a silicon epitaxial wafer according to the prior art will now be described. A silicon single crystal ingot is generally grown by the Czochralski (CZ) method, a floating zone (FZ) method, or the like. The grown silicon single crystal ingot is sliced and subjected to a rounding process (a cylindrical grinding process) to uniform a diameter. Then, a wafer-shaped silicon single crystal wafer is sliced out from this silicon single crystal ingot (a slicing process), and chamfering (a beveling process) is performed to round an edge of a peripheral portion of the sliced-out silicon single crystal wafer. Further, to eliminate irregularities on a surface of this silicon single crystal wafer, improve flatness, and minimize scratches on the surface, mechanical grinding (a lapping process: a wafer is called a lapped wafer at this stage) is performed, and a grinding damage layer formed on a surface layer of the silicon single crystal wafer at the time of mechanical grinding is removed by mixed acid etching (an etching process: a wafer is called an etched wafer at this stage).

Then, a donor-annihilation heat treatment for eliminating an oxygen donor is carried out, or a top coat (a dopant-volatilization-preventing top coat) for preventing auto-doping required for a low-resistance wafer is formed on a back side of the wafer. Subsequently, mirror polishing (a mirror polishing process: a wafer is called a polished wafer at this stage) for chemically and mechanically polishing (chemical-mechanical polishing: CMP) the surface with scratches, which cannot be removed by mechanical grinding, to form the surface of the wafer into a mirror state is performed. Moreover, a process of forming an epitaxial layer on the polished surface of the silicon single crystal wafer is carried out, whereby a silicon epitaxial wafer is manufactured. Such a method for manufacturing a silicon epitaxial wafer is described in, e.g., Patent Literature 1.

### Citation List

### Patent Literature

Patent Literature 1: Japanese Unexamined Patent Publication (Kokai) No. 2003-59933

### DISCLOSURE OF INVENTION

### PROBLEM TO BE SOLVED BY THE INVENTION

Among silicon single crystals that can be starting materials of such a silicon single crystal wafer for epitaxial growth, for the purpose of reducing resistance components of a switching operation, a single crystal with a super-low resistance having a large amount of arsenic or phosphorous doped therein has been demanded for a given type of power device such as an MOSFET. In particular, in a device process for performing a high-temperature heat treatment, there is a strong demand for a super-low resistance crystal having arsenic, which is less affected by thermal diffusion than phosphorous, doped therein.

However, when an arsenic-doped crystal used for a silicon single crystal wafer for epitaxial growth has a super-low resistance, manufacturing a silicon epitaxial wafer under conventional process conditions results in mass occurrence of stacking faults (SF) in a grown epitaxial layer, and device characteristics are deteriorated in some cases.

In view of the above-described problem, it is an object of the present invention to provide a method for manufacturing a silicon epitaxial wafer that enables suppressing occurrence of stacking faults at the time of performing epitaxial growth on an arsenic-doped super-low resistance silicon single crystal wafer.

### MEANS FOR SOLVING THE PROBLEMS

To achieve this object, according to the present invention, there is provided a method for manufacturing a silicon epitaxial wafer, characterized in that a silicon epitaxial layer is formed on an N-type silicon single crystal wafer manufactured by doping with arsenic to set a resistivity to 1.0 to 1.7 mΩcm and further doping with carbon, nitrogen, or both carbon and nitrogen.

As a result, it is possible to suppress formation of crystal defects that can be nuclei of staking faults that are produced at the time of forming the epitaxial layer, whereby the stacking faults produced in the epitaxial layer can be efficiently and assuredly avoided.

That is, according to the method for manufacturing a silicon epitaxial wafer of the present invention, the epitaxial layer having almost no stacking fault can be formed by the simple method on the arsenic-doped super-low resistance silicon single crystal wafer (a resistivity is 1.7 mΩcm or less) causing a large quantity of stacking faults when the conventional manufacturing method is performed, thereby manufacturing the high-quality silicon epitaxial wafer.

Here, it is possible that at the time of doping with carbon in the N-type silicon single crystal wafer, carbon-doped concentration is set to 0.2 to 5 ppma.

When the carbon concentration is set to 0.2 ppma or more, formation of crystal defects that can be nuclei of the stacking faults in the silicon crystal can be further assuredly suppressed, whereby the stacking faults caused in the epitaxial layer can be further efficiently and assuredly avoided. Further, to prevent formation of the nuclei of the stacking faults, carbon-doped concentration of 5 ppma can suffice.

Furthermore, it is possible that at the time of doping with nitrogen in the N-type silicon single crystal wafer, nitrogen-doped concentration is set to 1×10¹³ to 2×10¹⁴ atoms/cm³.

When the nitrogen concentration is set to 1×10¹³ atoms/cm³ or more, formation of crystal defects that can be nuclei of the stacking faults in the silicon crystal can be further assuredly suppressed, whereby the stacking faults caused in the epitaxial layer can be further efficiently and assuredly avoided. Further, to prevent formation of the nuclei of the stacking faults, nitrogen-doped concentration of 2×10¹⁴ atoms/cm³ can suffice.

### EFFECT OF THE INVENTION

According to the method for manufacturing a silicon epitaxial wafer of the present invention described above, the epitaxial layer having almost no stacking faults can be formed on the arsenic-doped super-low resistance N-type silicon single crystal wafer by the simple method, thereby manufacturing the high-quality silicon epitaxial wafer.

### BRIEF DESCRIPTION OF THE DRAWINGS

FIG. 1 is a flowchart showing an example of an embodiment of a method for manufacturing a silicon epitaxial wafer according to the present invention;
FIG. 2 is a graph showing a relationship between a resistivity of a wafer for epitaxial growth and the number of stacking faults caused in an epitaxial layer;
FIG. 3 is a graph showing a past result of a resistivity of wafers sliced out from arsenic-doped crystals; and
FIG. 4 is an observation view showing distributions of stacking faults in silicon epitaxial wafers manufactured in (a) Example 1, (b) Example 2, and (c) Comparative Example.

### BEST MODE FOR CARRYING OUT THE INVENTION

In the prior art, even though epitaxial growth is effected to an arsenic-doped silicon single crystal wafer (a resistivity is, e.g., 1.8 to 6.0 mΩcm), many stacking faults are not produced.

However, with a reduction in resistivity of the arsenic-doped silicon single crystal wafer, there occurs a problem that stacking faults are caused in an epitaxial layer.

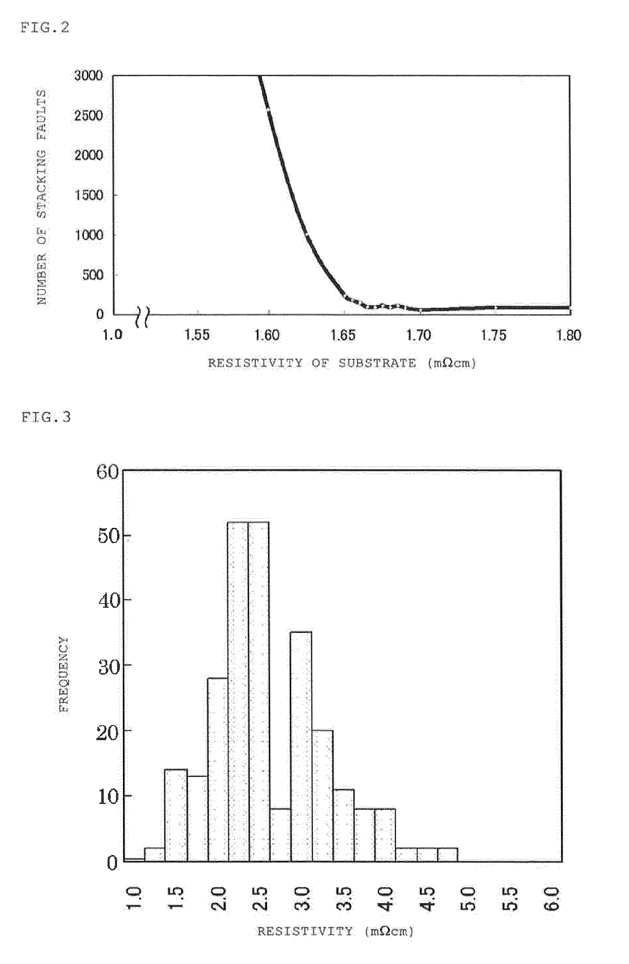

Meanwhile, as a result of keenly conducting examinations, the present inventors checked a relationship between a resistivity of a silicon single crystal wafer for epitaxial growth and the number of stacking faults caused in an epitaxial layer. FIG. 2 shows a result of the check. As shown in FIG. 2, the present inventors discovered that the number of stacking faults starts to increase in a wafer having a resistivity of 1.7 mΩcm or less and the number of stacking faults greatly increases in a wafer having a resistivity of 1.65 mΩcm or less.

Further, a lower limit of a resistivity of an arsenic-doped crystal having such super-low resistance is 1.0 mΩcm. FIG. 3 shows a past result of a resistivity of wafers sliced out from arsenic-doped crystals. An axis of ordinate in FIG. 3 represents the number of crystal ingots. As shown in FIG. 3, it is difficult to manufacture a wafer having a resistivity of 1.0 mΩcm, and an arsenic-doped silicon single crystal wafer having a resistivity of less than 1.0 mΩcm was not able to be actually manufactured.

As a result of further examinations, in regard to the stacking faults caused in such an epitaxial layer, the inventors discovered that crystal defects that can be nuclei of the stacking faults are formed in a silicon single crystal having the above-described arsenic doped therein in high concentration and a resistivity of 1.7 mΩcm or less and that the stacking faults are formed while using the crystal defects as nuclei at the time of forming the epitaxial layer. Furthermore, they found out that doping with carbon, nitrogen, or both carbon and nitrogen with respect to such a silicon single crystal enables suppressing formation of the crystal defects that can be nuclei of the stacking faults. As a result, they also discovered that, when such a silicon single crystal is used as a substrate of an epitaxial wafer, the stacking faults can be prevented from being caused in the epitaxial layer in subsequent epitaxial growth, thereby bringing the present invention to completion.

Although a method for manufacturing a silicon epitaxial wafer according to the present invention will now be described hereinafter in detail as embodiments with reference to the drawings, the present invention is not restricted thereto.

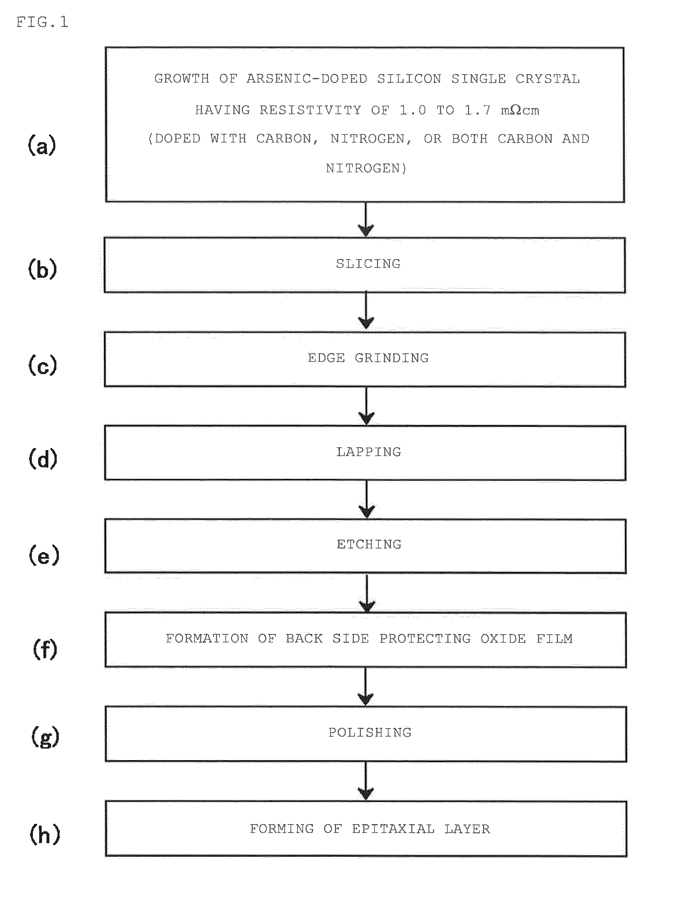

FIG. 1 is a flowchart showing an example of an embodiment of the method for manufacturing a silicon epitaxial wafer according to the present invention.

According to the method for manufacturing a silicon epitaxial wafer of the present invention, in a method for forming an epitaxial layer on a surface of a silicon single crystal wafer obtained by slicing a silicon single crystal to manufacture a silicon epitaxial wafer, at least, first, at the time of manufacturing an N-type silicon single crystal wafer which is doped with arsenic to set the resistivity to 1.0 to 1.7 mΩcm, especially 1.0 to 1.65 mΩcm, carbon, nitrogen, or both carbon and nitrogen are further doped.

Moreover, the invention is the method for manufacturing a silicon epitaxial wafer by which an epitaxial layer is formed on a surface of a silicon single crystal wafer that is sliced out from the manufactured silicon single crystal and subjected to a treatment such as mirror polishing.

The method will be more specifically explained hereinafter.

First, an N-type silicon single crystal is grown (FIG. 1(a)). Here, a situation where the single crystal is grown based on a CZ method will be explained, but this growth method itself is not restricted in particular, and it can be appropriately determined.

At the time of growing this silicon single crystal, the crystal is doped with arsenic in high concentration (approximately 8×10¹⁹ to 4×10¹⁹ atoms/cm³), and a resistivity of the silicon single crystal is thereby controlled to 1.0 to 1.7 mΩcm. At this time, the silicon single crystal is doped with carbon, nitrogen, or both carbon and nitrogen.

As described above, when the resistivity becomes 1.7 mΩcm or less by doping with arsenic, the number of stacking faults increases at the time forming an epitaxial layer. In particular, the number of stacking faults rapidly increases when the resistivity is 1.65 mΩcm or less. These phenomena are as described in conjunction with FIG. 2.

However, doping with carbon alone, nitrogen alone, or both carbon and nitrogen besides arsenic enables suppressing formation of crystal defects that can be nuclei of the stacking faults in the crystal. A super-low resistance silicon single crystal wafer is manufactured based on the silicon single crystal in which crystal defects are suppressed, and a silicon epitaxial layer is formed on a surface of this wafer, whereby the stacking faults can be efficiently and assuredly prevented from being caused in the epitaxial layer.

It is to be noted that fabrication of the single crystal is difficult in the first place, and hence the lower limit of the resistivity is set to 1.0 mΩcm.

At this time, carbon/nitrogen-doped concentration is not restricted in particular but, for example, the carbon concentration can be set to 0.2 to 5 ppma, and the nitrogen concentration can be set to 1×10¹³ to 2×10¹⁴ atoms/cm³.

If these concentration ranges are adopted, the stacking faults can be further efficiently and assuredly prevented from being caused at the time of forming the epitaxial layer without increasing costs and others beyond necessity.

Although a method for doping with arsenic, carbon, and nitrogen is not restricted in particular, it is possible to use a method for putting a silicon wafer containing these arsenic, carbon and nitrogen in a melt in a crucible in advance, a method for directly putting carbon powder or the like in the crucible in advance, or addition of a gas.

Subsequently, the grown silicon single crystal is ground into, e.g., a cylindrical shape, sliced by a wire saw (FIG. 1(b)), and formed into a wafer shape, whereby a silicon single crystal wafer is obtained.

Then, edge grinding is performed to chamfer (FIG. 1(c)), lapping is performed (FIG. 1(d)), and etching is carried out (FIG. 1(e)).

Subsequently, a back side protecting oxide film for preventing auto-doping is formed (FIG. 1(f)), and a wafer surface is subjected to mirror polishing (FIG. 1(g)).

Then, the silicon single crystal wafer is put into an epitaxial reaction chamber, a generally used source gas such as SiCl₄, SiHCl₃, SiH₂Cl₂, or SiH₄ is supplied into the reaction chamber, and an epitaxial layer having a desired thickness is formed (FIG. 1(h)).

Carrying out the method for manufacturing a silicon epitaxial wafer according to the present invention based on the above-described processes enables manufacturing the silicon epitaxial wafer having the epitaxial layer with no stacking faults formed thereon. Further, the process for avoiding occurrence of the stacking faults is not complicated, simply doping with arsenic and carbon or nitrogen in concentration that can provide a predetermined resistivity can suffice and, for example, these arsenic, carbon and nitrogen can be added to a melt in a crucible at the time of growing a single crystal as described above, thus very simply and efficiently enabling manufacture.

The above-described respective processes are not restricted in particular, a well-known technology can be used, and other processes such as cleaning or a heat treatment can be carried out between the processes.

### EXAMPLES

The present invention will now be more specifically explained based on examples and a comparative example, but the present invention is not restricted thereto.

### (Example 1)

An arsenic-doped N-type silicon single crystal having a diameter of 150 mm (6 inches), a resistivity of 1.53 mΩcm, and carbon concentration of 0.56 to 0.63 ppma was pulled up by the CZ method, sliced by a wire saw, and subjected to edge grinding, lapping, and etching processes.

Then, as a back side protecting oxide film, an oxide film having a thickness of approximately 500 nm was formed with the use of SiH₄ and O₂ gases by an atmospheric pressure CVD apparatus.

Subsequently, a front surface side of each of the silicon single crystal wafers was mirror-polished to remove pits. A polishing stock removal in this process was 5 µm.

A substrate for a silicon epitaxial wafer was manufactured in this manner.

Then, the silicon single crystal wafer was put into an epitaxial reaction chamber, SiHCl₃ as a source gas was supplied together with a hydrogen carrier gas, and a silicon epitaxial layer was formed.

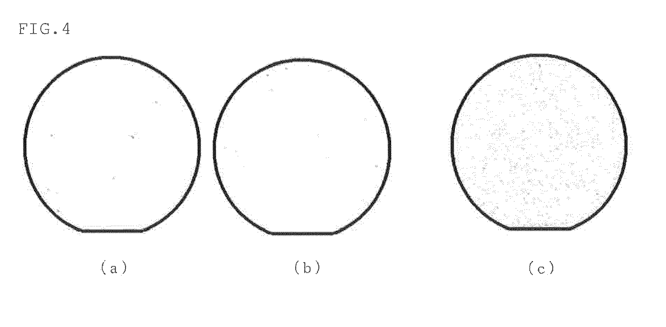

A distribution of stacking faults caused in the epitaxial layer of the thus manufactured silicon epitaxial wafer was observed by using a light scattering particle counter SP-1 (manufactured by KLA-Tencor). FIG. 4(a) shows its observation view.

Stacking faults whose size is larger than 0.1 µm were checked, and 27 stacking faults were observed within a wafer plane. As shown in FIG. 4(a), occurrence of the stacking faults was greatly suppressed, and it was confirmed that the excellent epitaxial layer was formed.

### (Example 2)

An arsenic-doped N-type silicon single crystal having a diameter of 150 mm (6 inches), a resistivity of 1.47 mΩcm, carbon concentration of 0.45 to 0.50 ppma, and nitrogen concentration of 6.00×10¹³ to 6.66×10¹³ atoms/cm³ was pulled up by the CZ method, a substrate for a silicon epitaxial wafer was fabricate, and a silicon epitaxial wafer was thereby manufactured like Example 1.

A distribution of stacking faults caused in an epitaxial layer of the thus manufactured silicon epitaxial wafer was observed like Example 1. FIG. 4(b) shows its observation view.

Stacking faults whose size is larger than 0.1 µm were checked, and 20 stacking faults were observed within a wafer plane. As shown in FIG. 4(b), occurrence of the stacking faults was greatly suppressed, and it was confirmed that the excellent epitaxial layer was formed.

### (Example 3)

An arsenic-doped N-type silicon single crystal having a diameter of 150 mm (6 inches), a resistivity of 1.47 mΩcm, and nitrogen concentration of 6.00×10¹³ to 6.66×10¹³ atoms/cm³ was pulled up by the CZ method, a substrate for a silicon epitaxial wafer was fabricated, and a silicon epitaxial wafer was thereby manufactured like Example 1.

A distribution of stacking faults caused in an epitaxial layer of the thus manufactured silicon epitaxial wafer was observed like Examples 1 and 2.

Stacking faults whose size is larger than 0.1 µm were checked, 29 stacking faults were observed within a wafer plane, and substantially the same observation view as FIG. 4(a) of Example 1 or FIG. 4(b) of Example 2 was obtained. Occurrence of the stacking faults was greatly suppressed, and it was confirmed that the excellent epitaxial layer was formed.

### (Comparative Example)

An arsenic-doped N-type silicon single crystal having a diameter of 150 mm (6 inches) and a resistivity of 1.50 mΩcm was pulled up by the CZ method with doping with neither carbon nor nitrogen. A substrate for a silicon epitaxial wafer was fabricated, and a silicon epitaxial wafer was thereby manufactured like Example 1.

A distribution of stacking faults produced in an epitaxial layer of the thus manufactured silicon epitaxial wafer was observed like each example. FIG. 4(c) shows its observation view.

Stacking faults whose size is larger than 0.1 µm were checked, and 1010 stacking faults were observed within a wafer plane. As shown in FIG. 4(c), it can be understood that many stacking faults were caused by crystal defects that were present in the substrate.

It is to be noted that the present invention is not restricted to the foregoing embodiment. The foregoing embodiment is an illustrative example, and any example that has substantially the same configuration and exercises the same functions and effects as the technical concept described in claims of the present invention is included in the technical scope of the present invention.

## Claims

1. A method for manufacturing a silicon epitaxial wafer, **characterized in that** a silicon epitaxial layer is formed on an N-type silicon single crystal wafer manufactured by doping with arsenic to set a resistivity to 1.0 to 1.7 mΩcm and further doping with carbon, nitrogen, or both carbon and nitrogen.

2. The method for manufacturing a silicon epitaxial wafer according to claim 1,
wherein, at the time of doping with carbon in the N-type silicon single crystal wafer, carbon-doped concentration is set to 0.2 to 5 ppma.

3. The method for manufacturing a silicon epitaxial wafer according to claim 1 or 2,
wherein, at the time of doping with nitrogen in the N-type silicon single crystal wafer, nitrogen-doped concentration is set to 1×10¹³ to 2×10¹⁴ atoms/cm³.
